# EUROPEAN PATENT APPLICATION

(11) **EP 3 267 458 A1**
(43) Date of publication of application: **10.01.2018**
(21) Application number: 16759057.9
(22) Date of filing: 04.03.2016
(51) Int. Cl.: H01H 9/02, F21V 23/04, H01H 9/16

(54) **PLANAR SWITCH AND MOUNTING METHOD FOR SAME PLANAR SWITCH**

(30) Priority: 05.03.2015 JP 2015043161
(71) Applicant: Minebea Mitsumi Inc., Kitasaku-gun, Nagano 3890293 (JP)
(72) Inventor: OMORI, Kiyoshi, Nagano 389-0293 (JP); OBATA, Yasutoshi, Nagano 389-0293 (JP)
(74) Representative: Liesegang, Eva
(86) International application number: PCT/JP2016/056900
(87) International publication number: WO 2016/140365

(57) **Abstract**

A plain-face switch (10) according to an embodiment is the mounted-type plain-face switch (10) that is mounted into an opening (1a), it includes a base unit (60) that is provided at the back of the opening (1a), a sensor module (30) that has a flat sensor surface facing the side of the opening (1a) and that is supported by the base unit(60), and a securing unit that secures the base unit (60) to the bottom surface, which is located at the back of the opening (1a), and the securing unit is capable of adjusting the position or the tilt of the sensor module (30) in the depth direction with respect to the opening (1a) such that the edge surface of the sensor module (30) at the side of the opening (1a) enters a predetermined state with respect to the opening (1a).

## Description

### Field

The present invention relates to a plain-face switch and a method for attaching the plain-face switch.

### Background

There are known light switches that are attached to a wall in a mounted state while in use and that may be also used as a remote controller by being removed from the wall (see Patent Literature 1). With the light switch in Patent Literature 1, as the switch is configured by using a capacitance sensor, the switch area is a plain surface.

### Citation List

### Patent Literature

Patent Literature 1: Japanese Laid-open Patent Publication No. 2012-059580

### Summary

### Technical Problem

Furthermore, in the case of plain-face switches that have a flat switch surface, it is considered that the switch surface is made flush with the wall so that the design of the wall may be improved. For this purpose, it is necessary to provide the wall with the opening that is equivalent to the outer shape of the switch and with the installation space that has the depth that is equivalent to the depth of the switch. However, there is a problem in that it is difficult to form the installation space that has an accurate outer shape and an accurate depth in the wall.

Furthermore, if the existing switch is removed and is replaced with a plain-face switch, there is much less flexibility of the opening and the depth for mounting the plain-face switch; therefore, it is difficult to obtain the installation space that conforms to the outer shape and the depth of the plain-face switch.

Furthermore, in the case of for example houses or conference rooms, even if it is possible to form the opening that has an outer shape that is equivalent to the outer shape of the plain-face switch, it is considered that it is extremely difficult to conform to the depth of the plain-face switch as the depth is defined by the distance between the inner wall and the outer wall.

The present invention has been made in consideration of the above-described problem, and it has an object to provide a mounted-type plain-face switch that is attachable such that the sensor module is located at the opening and that may be easily provided such that the sensor module is flush with the opening or may be provided such that it is tilted with respect to the opening, and a method for attaching the plain-face switch.

### Solution to Problem

To solve the problem and to achieve the object, a plain-face switch according to one embodiment of the present is the mounted-type plain-face switch that is mounted into an opening, it includes a base unit that is provided at the back of the opening, a sensor module that has a flat sensor surface facing the side of the opening and that is supported by the base unit, and a securing unit that secures the base unit to the bottom surface, which is located at the back of the opening, and the securing unit is capable of adjusting the position or the tilt of the sensor module in the depth direction with respect to the opening such that the edge surface of the sensor module at the side of the opening enters a predetermined state with respect to the opening.

According to the plain-face switch, the securing unit includes an elastic member that is provided between the base unit and the bottom surface and that is attached to the base unit, and a securing member that secures the base unit to the bottom surface.

According to the plain-face switch, the base unit includes a rectangular plane section and leg sections that extend from at least two opposing sides of the plane section toward the bottom surface. The elastic member is provided at least at four corners or a center of the plane section. The securing member is provided at least on the leg section in neighborhood of the four corners of the plane section.

According to the plain-face switch, the securing member is a thread. The plain-face switch includes a packing that is provided to cover a clearance between the sensor module and an edge of the opening.

According to the plain-face switch, the securing member includes a guide pin that is secured to the bottom surface and an adhesive agent that attaches the base unit to the guide pin.

According to the plain-face switch, the elastic member is a coil spring. The base unit includes a protruding section that protrudes toward the bottom surface and that has one end side of the coil spring fitted therewith. The protruding section is provided with a locking projection that locks the coil spring.

According to the plain-face switch, the sensor module includes a capacitance type sensor unit.

According to the plain-face switch, the sensor module includes a cover unit that is provided on side of the opening and that is located at the opening, and a sensor main body to which the cover unit is attached.

According to the plain-face switch, the sensor module includes a backlight that is provided between the cover unit and the sensor main body, and an indication unit that is provided between the backlight and the cover unit. The cover unit is made of a light transmissive material.

According to the plain-face switch, the sensor module includes a backlight that is provided between the cover unit and the sensor main body. The cover unit is made of a light transmissive material and has an indication printed thereon.

The plain-face switch includes a switch box to which the sensor main body is attached. According to the plain-face switch, the switch box is attached to the base unit at the side of the opening so that the sensor module is supported by the base unit via the switch box.

The plain-face switch includes a spacer that is attached to the switch box. According to the plain-face switch, the sensor main body includes a securing box that is attached to the spacer, a securing plate that is attached to the securing box, and a sensor unit that is attached to the securing plate.

According to the plain-face switch, the securing unit is capable of adjusting a position and a tilt of the sensor module in a depth direction with respect to the opening so that the predetermined state is obtained such that the edge surface of the sensor module at the side of the opening is flush with the opening.

A method according to one embodiment of the present for attaching a mounted-type plain-face switch that is attachable such that a sensor module is located at an opening includes securing a base unit to a bottom surface at back of the opening with a securing unit, supporting the sensor module by the base unit such that a flat sensor surface faces side of the opening and adjusting a secured state of the base unit by the securing unit so as to adjust a position or a tilt of the sensor module in a depth direction with respect to the opening such that an edge surface of the sensor module at the side of the opening enters a predetermined state with respect to the opening.

### Advantageous Effects of Invention

According to the present invention, it is possible to provide a mounted-type plain-face switch that is attachable such that the sensor module is located at the opening and that may be easily provided such that the sensor module is flush with the opening or may be provided such that it is tilted with respect to the opening, and a method for attaching the plain-face switch.

### Brief Description of Drawings

FIG. 1 is an enlarged perspective view of the neighborhood of a plain-face switch in a case where the plain-face switch according to a first embodiment is provided on a wall in a mounted manner.
FIG. 2 is an exploded perspective view of the plain-face switch according to the first embodiment.
FIG. 3 is an exploded perspective view of a sensor main body according to the first embodiment.
FIG. 4A is a diagram that illustrates the operation principal of the sensor unit according to the first embodiment, and it is a diagram that illustrates a state where a switch operation is not performed.
FIG. 4B is a diagram that illustrates the operation principal of the sensor unit according to the first embodiment, and it is a diagram that illustrates a state where a switch operation is performed.
FIG. 5 is a perspective view of the back surface side of a base unit according to the first embodiment.
FIG. 6 is a cross-sectional view that is taken along a line A-A in FIG. 5, and it is a diagram from which a part of elastic members are omitted.
FIG. 7A is a diagram that illustrates the method for attaching the plain-face switch according to the first embodiment, and it is a perspective view that illustrates an opening being provided on an outer wall.
FIG. 7B is a diagram that illustrates the method for attaching the plain-face switch according to the first embodiment, and it is a perspective view that illustrates a thread hole being provided on an inner wall.
FIG. 8A is a diagram that illustrates the method for attaching the plain-face switch according to the first embodiment, and it is a perspective view that illustrates a securing step for securing the base unit.
FIG. 8B is a diagram that illustrates the method for attaching the plain-face switch according to the first embodiment, and it is a side view when FIG. 8A is viewed in the X direction.
FIG. 9 is a diagram that illustrates the method for attaching the plain-face switch according to the first embodiment, and it is a perspective view that illustrates a supporting step for supporting a sensor module by the base unit.
FIG. 10 is a diagram that illustrates the method for attaching the plain-face switch according to the first embodiment, and it is a perspective view that illustrates the supporting step for supporting the sensor module by the base unit.
FIG. 11A is a diagram that illustrates the method for attaching the plain-face switch according to the first embodiment, and it is a front view that illustrates a state after the supporting step is finished.
FIG. 11B is a diagram that illustrates the method for attaching the plain-face switch according to the first embodiment, and it is a side view when FIG. 11A is viewed in the Y direction.
FIG. 12 is a diagram that illustrates the method for attaching the plain-face switch according to the first embodiment, and it is a side view that illustrates the adjustment step for adjusting the sensor module according to the first embodiment to enter a predetermined state.
FIG. 13A is a diagram that illustrates the method for attaching the plain-face switch according to the first embodiment, and it is a perspective view that illustrates a state before a packing is attached.
FIG. 13B is a diagram that illustrates the method for attaching the plain-face switch according to the first embodiment, and it is a perspective view that illustrates a state after a packing is attached.
FIG. 14A is a diagram that illustrates the method for attaching the plain-face switch according to a second embodiment, and it is a perspective view that illustrates an opening being provided on the outer wall.
FIG. 14B is a diagram that illustrates the method for attaching the plain-face switch according to the second embodiment, and it is a perspective view that illustrates a guide pin being provided on the inner wall.
FIG. 15 is a diagram that illustrates the method for attaching the plain-face switch according to the second embodiment, and it is a side view that illustrates a state where the base unit is placed on the inner wall through the guide pin.
FIG. 16 is a diagram that illustrates the method for attaching the plain-face switch according to the second embodiment, and it is a side view that illustrates a state where the end of the guide pin is provided with an adhesive agent.
FIG. 17 is a diagram that illustrates the method for attaching the plain-face switch according to the second embodiment, and it is a side view that illustrates a state after the supporting step is finished.
FIG. 18 is a diagram that illustrates the method for attaching the plain-face switch according to the second embodiment, and it is a side view that illustrates the adjustment step for adjusting the sensor module to enter a predetermined state.
FIG. 19 is an exploded perspective view that illustrates a modification of the sensor module.
FIG. 20 is a perspective view when the base unit according to the modification of the first and the second embodiments is viewed from the front side.
FIG. 21 is a perspective view when the base unit according to the modification of the first and the second embodiments is viewed from the back surface.

### Description of Embodiments

A detailed explanation is given below of the configuration (referred to as "embodiment" below) for implementing the present invention with reference to the attached drawings. Furthermore, the same elements are attached with the same number in the entire explanation of embodiments.

### (First embodiment)

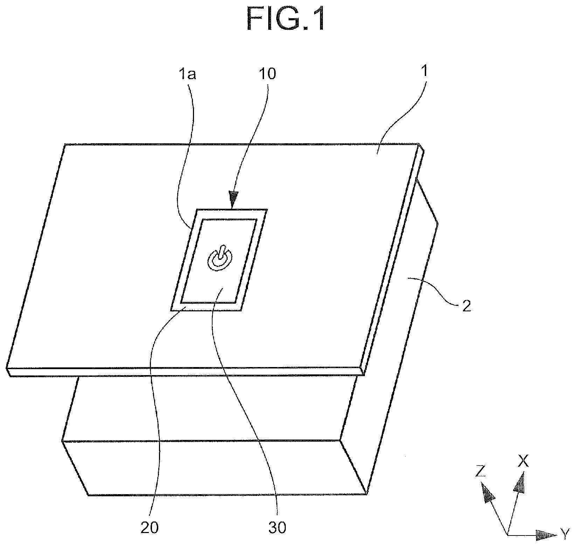

FIG. 1 is a diagram that illustrates a case where a mounted-type plain-face switch 10 according to a first embodiment is provided on a wall surface of a house, or the like, in a mounted manner, and it is an enlarged perspective view of the enlarged neighborhood of the plain-face switch 10. As illustrated in FIG. 1, the plain-face switch 10 is provided on an inner wall 2 such that it is substantially flush with an opening 1a of an outer wall 1. Furthermore, the plain-face switch 10 includes a packing 20 that covers the clearance with the opening 1a of the outer wall 1.

Here, with regard to the XYZ axes that are illustrated in FIG. 1, the Z axis indicates the front-back direction of the depth of the opening 1a (i.e., the direction from the inner wall 2 toward the outer wall 1 or from the outer wall 1 toward the inner wall 2), the X axis indicates the up-and-down direction in a state where the plain-face switch 10 is provided on the wall surface, and the Y axis indicates the right-and-left direction in a state where the plain-face switch 10 is provided on the wall surface.

If the XYZ axes are illustrated in the subsequent figures, the XYZ axes are described according to the foregoing, and the direction along the X axis is sometimes referred to as the X direction, the direction along the Y axis as the Y direction, and the direction along the Z axis as the Z direction.

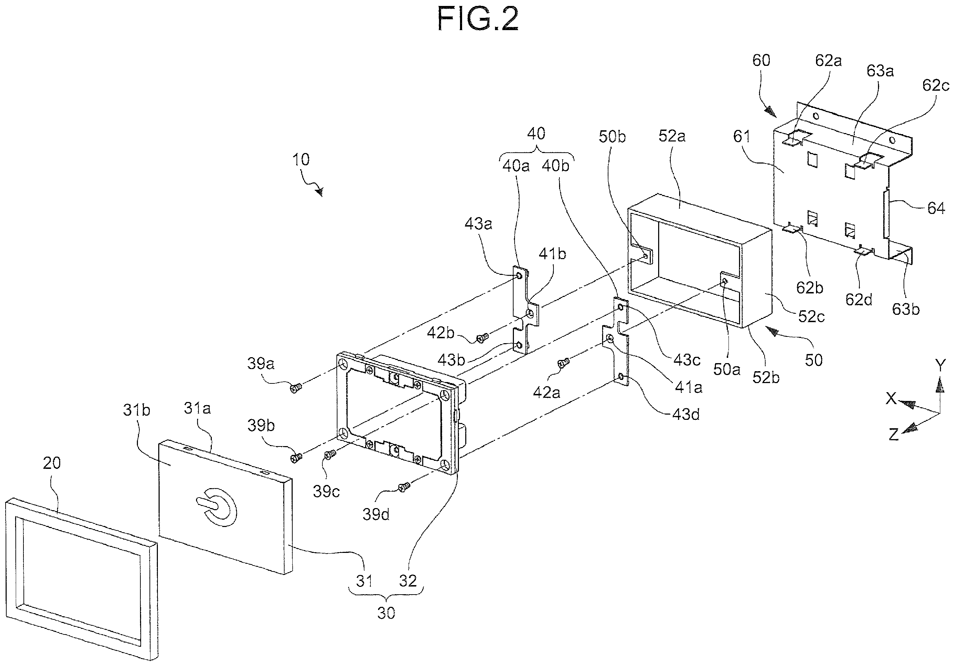

FIG. 2 is an exploded perspective view that illustrates only the plain-face switch 10. Here, FIG. 2 illustrates the plain-face switch 10 laterally although it is illustrated longitudinally in FIG. 1. Specifically, as illustrated with the XYZ axes in FIG. 2, the up-and-down direction (the Y direction) in FIG. 2 is the right-and-left direction (the Y direction) when the plain-face switch 10 is provided on the wall surface in FIG. 1, and the Z direction from the upper right side of FIG. 2 toward the lower left side is the front-back direction (the Z direction) of the opening 1a in FIG. 1, and the X direction from the upper left side of FIG. 2 toward the lower right side is the up-and-down direction (the X direction) when the plain-face switch 10 is provided on the wall surface in FIG. 1.

As illustrated in FIG. 2, the plain-face switch 10 includes the packing 20, a sensor module 30, a spacer 40, a switch box 50, and a base unit 60.

### (Packing)

The packing 20 covers the clearance between the opening 1a (see FIG. 1) of the outer wall 1 and the sensor module 30; its material is not particularly limited, and a material, such as hard rubber, is used to form it.

### (Sensor module)

As illustrated in FIG. 2, the sensor module 30 includes a cover unit 31 and a sensor main body 32.

### [Cover unit]

The cover unit 31 is provided in the sensor module 30 at the side of the opening 1a (see FIG. 1) of the outer wall 1, and it has a function to protect a sensor of the sensor main body 32.

Furthermore, in the cover unit 31, a back surface 31a, which is on the side of the sensor module 30, and a front surface 31b, which is on the opposite side, are flat surfaces, and when the sensor module 30 is positioned on the opening 1a (see FIG. 1) of the outer wall 1, it may be substantially flush with the opening 1a of the outer wall 1.

Here, according to the present embodiment, the front surface 31b of the cover unit 31 is an edge surface of the sensor module 30 at the side of the opening 1a; however, if the cover unit 31 is not provided and the sensor module 30 includes only the sensor main body 32, an edge surface of the sensor main body 32 at the side of the opening 1a is an edge surface of the sensor module 30 at the side of the opening 1a.

Furthermore, according to the present embodiment, the mark of the switch is illustrated on the front surface 31b of the cover unit 31 such that it is aligned with the position of the sensor of the sensor main body 32 so that it is possible to know where the switch is on the outer wall 1. Here, the mark of the switch may be illustrated on the front surface 31b of the cover unit 31 not only by printing but also by providing concavity and convexity on the front surface 31b of the cover unit 31, for example, by carving. Therefore, the front surface 31b of the cover unit 31 being a flat surface does not mean that there are no concavity and convexity at all on the surface, but it means that the front surface 31b is a flat surface when it is viewed as a whole.

### [Sensor main body]

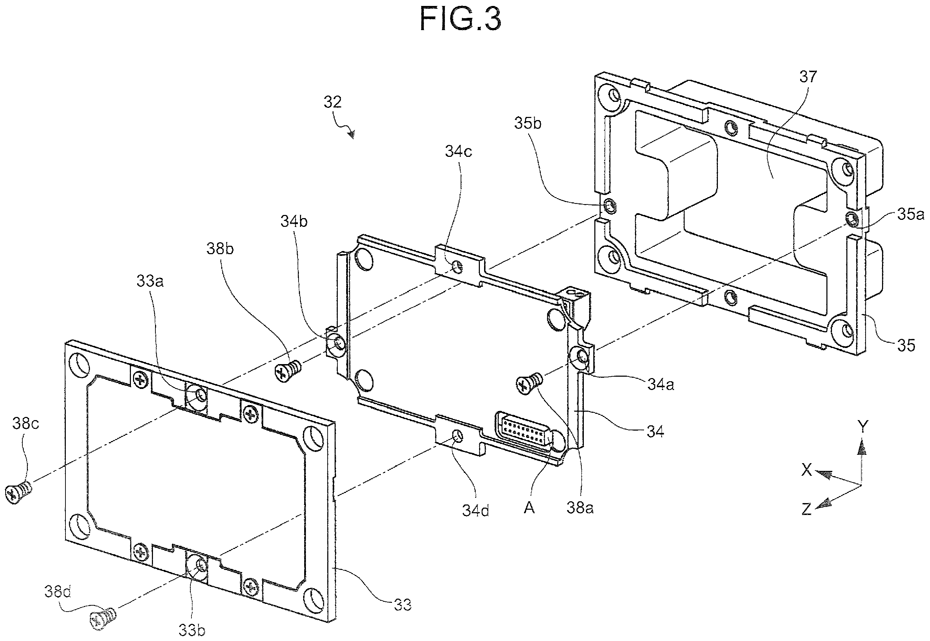

FIG. 3 is an exploded perspective view that illustrates only the sensor main body 32. Here, as illustrated with the XYZ axes, FIG. 3 also has an illustration laterally in the same manner as in FIG. 2, contrary to the longitudinal illustration in FIG. 1. As illustrated in FIG. 3, the sensor main body 32 includes a capacitance-type sensor unit 33, a securing plate 34, and a securing box 35.

According to the present embodiment, as the capacitance-type sensor unit 33 is used, the sensor surface of the sensor unit 33, which face the side of the opening 1a, is a flat surface. If the finger of a person, or the like, is located close, the sensor unit 33 detects it and performs an operation to turn on or off the switch.

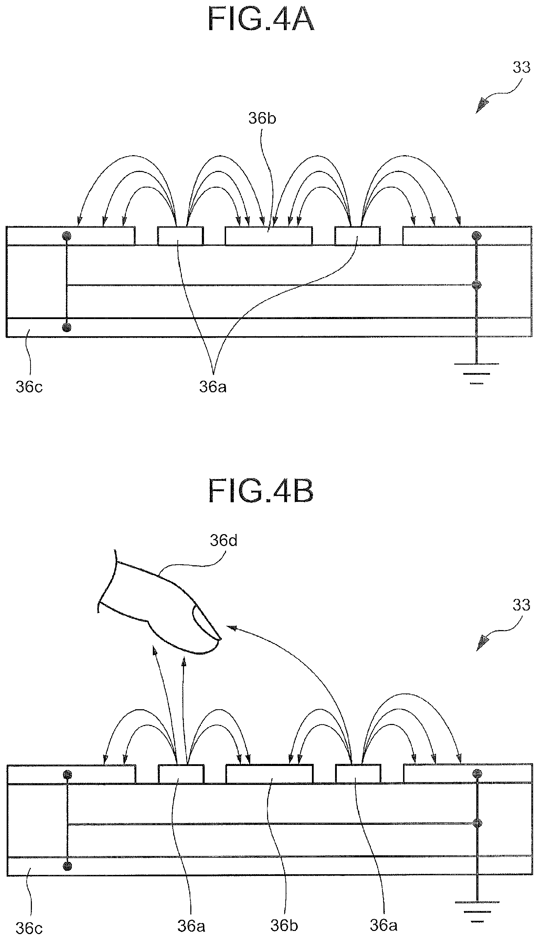

The used sensor unit 33 according to the present embodiment is based on detection of changes in the capacitance (the line of electric force). More specifically, as illustrated in FIG. 4A, the sensor unit 33 includes a drive line 36a, a sensor line 36b, and a ground 36c. Furthermore, an electric field occurs among the drive line 36a, the sensor line 36b, and the ground 36c, and the state of the electric field is represented by using an arrow that is the line of electric force in FIG. 4A and FIG. 4B that is described below.

In this state, as illustrated in FIG. 4B, when a person's finger 36d is located close, the line of electric force is pulled toward the finger 36d, and the number of lines of electric force to the sensor line 36b is decreased. By detecting a decrease in the lines of electric force, i.e., a change in the capacitance, it is detected whether an operation of the switch is performed.

Furthermore, other capacitance-type sensor units may be used; however, in the case of the above-described sensor unit 33 that detects changes in the line of electric force according to the present embodiment, even if the finger 36d is separated from the sensor front surface, the finger 36d may be detected when it is located nearby.

Therefore, design flexibility of the cover unit 31 maybe improved, such as increasing the thickness of the cover unit 31, as compared to a capacitance-type sensor unit for which there is a need to bring the finger 36d close such that the finger 36d is in contact with the sensor front surface.

Furthermore, it may be detected that the finger 36d is located nearby if there is a space (air layer), or the like, between the cover unit 31 and the sensor front surface. Therefore, it is not necessary to care about the space that is formed between the cover unit 31 and the sensor unit 33 during assembling, and the plain-face switch 10 without the need of severer dimensional management or high assembly accuracy may be configured.

An explanation of the sensor main body 32 is continued with reference back to FIG. 3. As illustrated in FIG. 3, the securing box 35 is provided with a space 37. In the space 37, a controller A is arranged, which is provided on the back surface of the securing plate 34, located on the opposite of the front surface that faces the sensor unit 33. Here, FIG. 3 illustrates only the connector section of the controller A, which is connected to the sensor unit 33.

Furthermore, the securing box 35 is provided with thread fastening holes 35a, 35b on both edges in the X direction. Moreover, undepicted internal thread structures (helical grooves), which correspond to the external thread structure of a thread, are formed on the inner circumferences of the thread fastening holes 35a, 35b.

Furthermore, thread holes 34a, 34b are provided on both edges of the securing plate 34 in the X direction, and tapered flanges, which receive threads 38a, 38b, are provided on the circumferential edges of the thread holes 34a, 34b.

Therefore, the securing plate 34 may be secured to the securing box 35 as described below. First, the securing plate 34 with the controller A attached to the back surface of the securing plate 34 is mounted on the securing box 35 such that the controller A is located in the space 37 of the securing box 35.

Next, as indicated by the dashed-dotted line in FIG. 3, the threads 38a, 38b are inserted into the thread holes 34a, 34b of the securing plate 34 from the front surface side, and the threads 38a, 38b are engaged with the thread fastening holes 35a, 35b of the securing box 35; thus, securing of the securing plate 34 to the securing box 35 is completed.

Furthermore, as illustrated in FIG. 3, the sensor unit 33 is provided with a pair of thread holes 33a, 33b on both edges in the Y direction, and tapered flanges, which receive threads 38c, 38d, are provided on the circumferential edges of the thread holes 33a, 33b.

Furthermore, the securing plate 34 is provided with a pair of thread fastening holes 34c, 34d on both edges in the Y direction. Moreover, undepicted internal thread structures (helical grooves), which correspond to the external thread structures of the threads 38c, 38d, are formed on the inner circumferences of the thread fastening holes 34c, 34d.

Therefore, by using the threads 38c, 38d, the sensor unit 33 may be secured to the securing plate 34, which is secured to the securing box 35 as described above.

More specifically, first, the sensor unit 33 is mounted on the securing plate 34, which is secured to the securing box 35.

Next, as indicated by the dashed-dotted line in FIG. 3, the threads 38c, 38d are inserted into the thread holes 33a, 33b from the front surface side of the sensor unit 33, which is on the opposite side of the side of the securing plate 34, and the threads 38c, 38d are engaged with the thread fastening holes 34c, 34d of the securing plate 34; thus, securing of the sensor unit 33 to the securing plate 34 is completed. Furthermore, when the sensor unit 33 is mounted on the securing plate 34., the sensor unit 33 is connected to the connector section of the controller A.

As described above, when the sensor unit 33, the securing plate 34, and the securing box 35 are assembled, the sensor main body 32 is obtained as illustrated in FIG. 2.

### (Spacer)

The spacer 40 is a component that secures the sensor main body 32 to the switch box 50. According to the present embodiment, as the spacer 40, a pair of spacers 40a, 40b is provided, which corresponds to a pair of thread fastening holes 50a, 50b of the switch box 50, as illustrated in FIG. 2. The spacers 40a, 40b are provided with thread holes 41a, 41b, respectively, and tapered flanges, which receive threads 42a, 42b, are provided on the circumferential edges of the thread holes 41a, 41b.

Furthermore, undepicted internal thread structures (helical grooves), which correspond to the external thread structures of the threads 42a, 42b, are formed on the inner circumferences of the thread fastening holes 50a, 50b in pair in the switch box 50.

Therefore, as indicated by the dashed-dotted line in FIG. 2, the threads 42a, 42b are inserted into the thread holes 41a, 41b of the spacers 40a, 40b, respectively, and the threads 42a, 42b are engaged with the thread fastening holes 50a, 50b of the switch box 50, whereby the spacers 40a, 40b are secured to the switch box 50.

Here, each of the spacers 40a, 40b is provided with a pair of thread fastening holes on the top and the bottom as viewed in the drawing. More specifically, the spacer 40a is provided with a pair of thread fastening holes 43a, 43b on the top and the bottom as viewed in the drawing, and the spacer 40b is provided with a pair of thread fastening holes 430, 43d on the top and the bottom as viewed in the drawing.

Furthermore, undepicted internal thread structures (helical grooves), which correspond to the external thread structure of the threads 39a, 39b, 39c, and 39d, are formed on the inner circumferences of the thread fastening holes 43a, 43b, 43c, and 43d.

Furthermore, the sensor main body 32 is provided with thread holes, through which the threads 39a, 39b, 39c, and 39d are inserted, on four corners. Moreover, as it is understood from the illustration of the securing box 35 in FIG. 3, tapered flanges, which receive the threads 39a, 39b, 39c, and 39d, are provided on the hole circumferential edges of the thread holes on the four corners.

Therefore, as described above, after the spacers 40a, 40b are secured to the switch box 50, the threads 39a, 39b, 39c, and 39d are inserted into the thread holes on the four corners of the sensor main body 32, and the threads 39a, 39b, 39c, and 39d are engaged with the thread fastening holes 43a, 43b, 43c, and 43d of the spacers 40a, 40b, as indicated by the dashed-dotted line in FIG. 2, whereby the sensor main body 32 is secured to the switch box 50.

### (Switch box)

As illustrated in FIG. 2, the switch box 50 is a member that is attached to a plane section 61 of the base unit 60. More specifically, holding pieces 62a, 62b and 62c, 62d are provided as two pairs such that they are separated in the X direction, they are arranged on the surface (on the left side in the Z direction in FIG. 2) of the plane section 61, which faces the opening 1a (see FIG. 1) of the outer wall 1, they make a pair on two sides of the plane section 61 of the base unit 60 in the Y direction, and the holding pieces 62a, 62b and 62c, 62d hold two side walls 52a, 52b of the switch box 50 in the Y direction, whereby the switch box 50 is attached to the base unit 60.

Therefore, according to the present embodiment, the sensor main body 32 is supported by the base unit 60 via the switch box 50. However, a configuration may be such that the base unit 60 itself is provided with a structure for securing the sensor main body 32 and the sensor main body 32 is directly supported by the base unit 60.

As the switch box 50 according to the present embodiment, a commercially available switch box, which conforms to the standard of JIS, is used. Therefore, for example, if the existing switch is replaced with the plain-face switch according to the present embodiment, the existing switch box may be reused. Furthermore, with this configuration, the base unit 60 itself may be manufactured in conformity to the typical switch box 50; thus, general versatility of the base unit 60 may be improved.

### (Base unit)

As illustrated in FIG. 2, the base unit 60 includes the plane section 61 and leg sections 63a, 63b that are provided on at least two opposing sides of the plane section 61. According to the present embodiment, the leg sections 63a, 63b are provided on two sides, opposing in the Y direction, of the plane section 61.

In FIG. 2, as described above, the right side of the figure in the Z direction is in the depth direction of the opening 1a of the outer wall 1 in FIG. 1. Therefore, the leg sections 63a, 63b are formed such that they extend on the side of the inner wall 2, illustrated in FIG. 1, i.e., on the side of the bottom surface for the opening 1a. Furthermore, the plane section 61 is provided with a switch-box support section 64 that supports the switch box 50 on the right side in the X direction.

The right side in the X direction in FIG. 2 is the lower side in the X direction in FIG. 1; therefore, it is equivalent to the lower side when the plain-face switch 10 is mounted on the wall surface. Therefore, in a state where the switch box 50 is actually attached to the wall surface, it is supported at the lower side by the switch-box support section 64 of the base unit 60.

In this way, the switch box 50 is secured to the base unit 60 not only by the holding pieces 62a, 62b and 62c, 62d of the base unit 60 but also by being supported by the switch-box support section 64 at the bottom. As a result, the switch box 50 is secured to the base unit 60 in a more stable manner as compared to the case where it is secured by only the holding pieces 62a, 62b and 62c, 62d.

Furthermore, as described below in detail, the base unit 60 is a securing unit that is capable of adjusting the position and the tilt of the sensor module 30 in the depth direction with respect to the opening 1a (see FIG. 1), and it is secured to the inner wall 2 that is located at the back of the opening 1a, illustrated in FIG. 1.

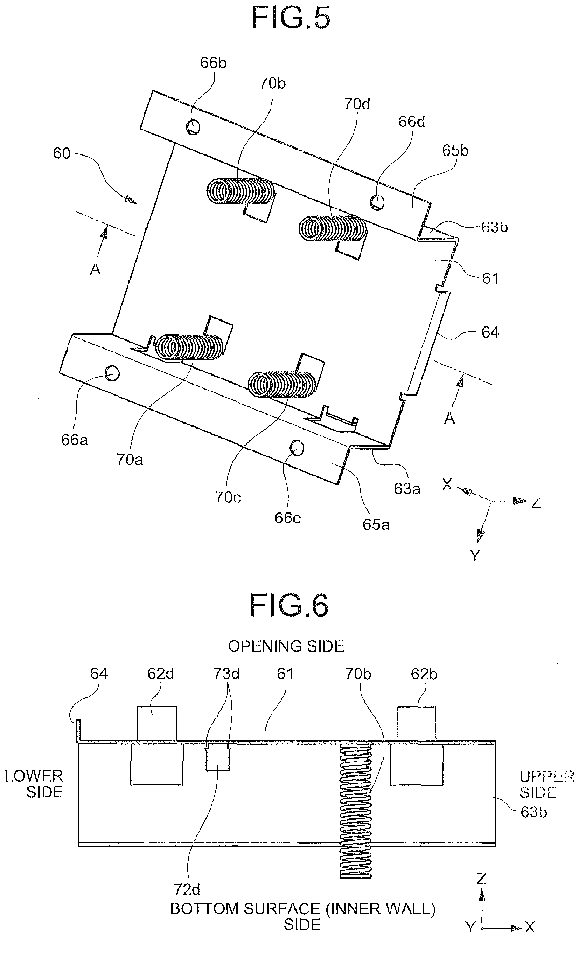

A detailed explanation is given below of the configuration of the securing unit according to the first embodiment which is capable of adjusting the position and the tilt in the depth direction. FIG. 5 is a perspective view of the base unit 60 when it is viewed from the side of the inner wall 2, which is at the back of the opening 1a in FIG. 1, after the base unit 60, illustrated in FIG. 2, is turned over in the front-back direction (the direction along the Z direction). That is, FIG. 5 is a perspective view that illustrates the side of the back surface of the plane section 61 in the base unit 60, and in FIG. 5, the left side in the Z direction is the side of the inner wall 2, and the right side in the Z direction is the side of the opening 1a.

Here, the present embodiment describes the case where the plain-face switch 10 is secured to the inner wall 2, which is located at the back of the opening 1a; however, the area where the plain-face switch 10 is secured is not necessarily the inner wall 2 and therefore the inner wall 2 is described below as the bottom surface that is located at the back of the opening 1a. Furthermore, as the bottom surface according to the present embodiment is the inner wall 2, the bottom surface (the inner wall 2) is mentioned in the description.

As illustrated in FIG. 5, the base unit 60 is provided with four elastic members 70a, 70b, 70c, and 70d, which are coil springs and which are arranged on four corners with reference to the center of the back surface of the plane section 61.

Here, the four corners do not mean the absolute edges but they mean the positions that are offset to four corner sides with reference to the center of the plane section 61 so as to receive the plane section 61 in a well-balanced manner when it is received. Furthermore, although coil springs are used as the elastic members 70a, 70b, 70c, and 70d according to the present embodiment, there is not necessarily limitation on coil springs.

Furthermore, the lengths of the used elastic members 70a, 70b, 70c, and 70d, i.e., coil springs, are longer than the lengths of the leg sections 63a, 63b of the base unit 60 in a state where they are fully stretched without any loads being applied.

FIG. 6 is a cross-sectional view that is taken along a line A-A in FIG. 5. In FIG. 6, the upper side in the Z direction is the side of the opening 1a in FIG. 1, and the lower side in the Z direction is the side of the bottom surface (the inner wall 2) in FIG. 1. Furthermore, in FIG. 6, the left side in the X direction is the lower side in the X direction in FIG. 1 and it is the right side in the X direction in FIG. 5, and the right side in the X direction is the upper side in the X direction in FIG. 1 and it is the left side in the X direction in FIG. 5.

In FIG. 6, the elastic member 70d is removed so that the structure for attaching the elastic member, provided on the base unit 60, may be understood. Specifically, the base unit 60 includes a protruding section 72d that protrudes from the plane section 61 toward the bottom surface (the inner wall 2) so that one end of the elastic member 70d (coil spring) is fitted therewith.

Furthermore, the protruding section 72d is provided with a locking projection 73d that is formed to be slightly larger than the inner diameter of the elastic member 70d (coil spring) to lock the elastic member 70d (coil spring).

Thus, the elastic member 70d (coil spring) is pushed over the locking projection 73d and the elastic member 70d (coil spring) is locked, whereby the elastic member 70d is prevented from being pulled out of the protruding section 72d. Furthermore, the other elastic members 70a, 70b, and 70c are secured to the plane section 61 of the base unit 60 with the protruding sections that have the same structure.

In this manner, during an operation to install the plain-face switch 10, the elastic members 70a, 70b, 70c, 70d are prevented from being separated from the base unit 60, whereby the operating efficiency of the operation to install the plain-face switch 10 may be improved.

Furthermore, as illustrated in FIG. 5, the ends of the leg sections 63a, 63b are bent sections 65a, 65b that are bent so as to conform with the bottom surface (the inner wall 2) to which the base unit 60 is secured. Moreover, each of the bent sections 65a, 65b is provided with two thread holes, through which a thread is inserted.

Specifically, the bent section 65a is provided with thread holes 66a, 66c, the bent section 65b is provided with thread holes 66b, 66d, and the thread holes 66a, 66b, 66c, and 66d are provided on the leg sections 63a, 63b such that they conform to the neighborhoods of the four corners of the plane section 61.

Furthermore, threads are used as securing members for securing the base unit 60 to the bottom surface (the inner wall 2), and the threads are screwed into the bottom surface (the inner wall 2) through the thread holes 66a, 66b, 66c, and 66d so that the base unit 60 is secured to the bottom surface (the inner wall 2).

Here, as described above, the used elastic members 70a, 70b, 70c, and 70d are longer than the lengths of the leg sections 63a, 63b of the base unit 60 in a state where they are fully stretched without any loads being applied, although the secured state is described in detail later.

Therefore, without screwing the threads until a state is such that the bent section 65a of the leg section 63a and the bent section 65b of the leg section 63b are brought into contact with the bottom surface (the inner wall 2), a state is obtained such that the base unit 60 is fixed due to the biasing forces of the elastic members 70a, 70b, 70c, and 70d that are provided between the bottom surface (the inner wall 2) and the base unit 60 (the plane section 61).

In this way, as the securing unit is made up of the elastic members 70a, 70b, 70c, and 70d and the securing member (thread), the base unit 60 may be fixed in a state (floating state) where it is separated from the bottom surface (the inner wall 2) and, by changing the screwing degree of each thread, the position and the tilt in the depth direction may be changed.

Furthermore, changes in the position and the tilt in the depth direction mean changes in the position and the tilt of the sensor module 30, supported by the base unit 60, in the depth direction. That is, the securing unit, including the elastic members 70a, 70b, 70c, and 70d and the threads as securing members, according to the present embodiment is the securing unit that is capable of adjusting the position and the tilt of the sensor module 30 in the depth direction with respect to the opening 1a such that, for example, a predetermined state is obtained such that the edge surface of the sensor module 30 at the side of the opening 1a is flush with the opening 1a or a predetermined state is obtained such that it is tilted with respect to the opening 1a.

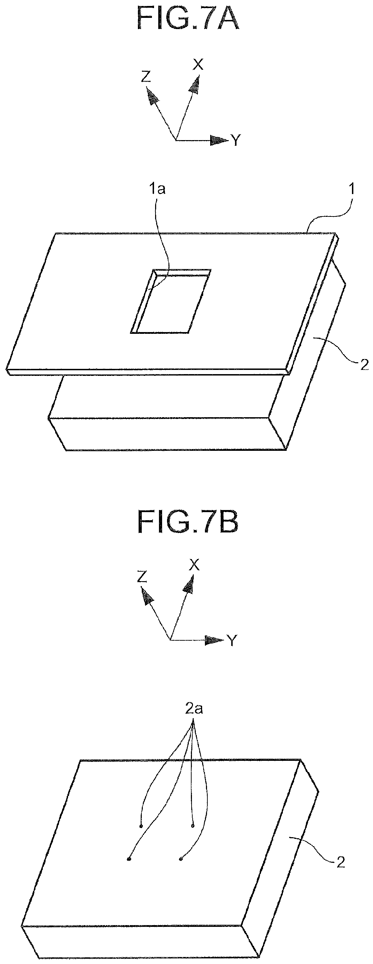

With reference to FIGS. 7A to FIG. 13B, an explanation is given of the method for securing the mounted-type plain-face switch 10 that is configured as described above according to the first embodiment. First, as illustrated in FIG. 7A, the opening 1a is formed on the outer wall 1. At this point, as illustrated in FIG. 7B, four thread holes 2a for screwing the securing members (threads) to secure the base unit 60 (not illustrated) through the opening 1a (not illustrated) are formed on the bottom surface (the inner wall 2). Here, FIG. 7B omits the illustration of the outer wall 1 to make it easier to understand the state of the bottom surface (the inner wall 2). Hereafter, although the outer wall 1 is sometimes omitted to principally illustrate the state of the bottom surface (the inner wall 2), it should be noted that the outer wall 1 is present in actuality.

If the bottom surface (the inner wall 2) is a material, such as wood, which may be processed relatively easily, the thread hole 2a does not need to be provided with an internal thread structure (helical groove) on its inner circumference, and a hole only has to be formed as an opening, through which a thread starts to be inserted. Furthermore, for example, in a case where the existing switch is replaced with the plain-face switch 10, as there is the opening 1a of the outer wall 1, illustrated in FIG. 7A, there is no need for the task of forming the opening 1a in such a case, and the thread hole 2a only has to be provided on the bottom surface (the inner wall 2) as illustrated in FIG. 7B.

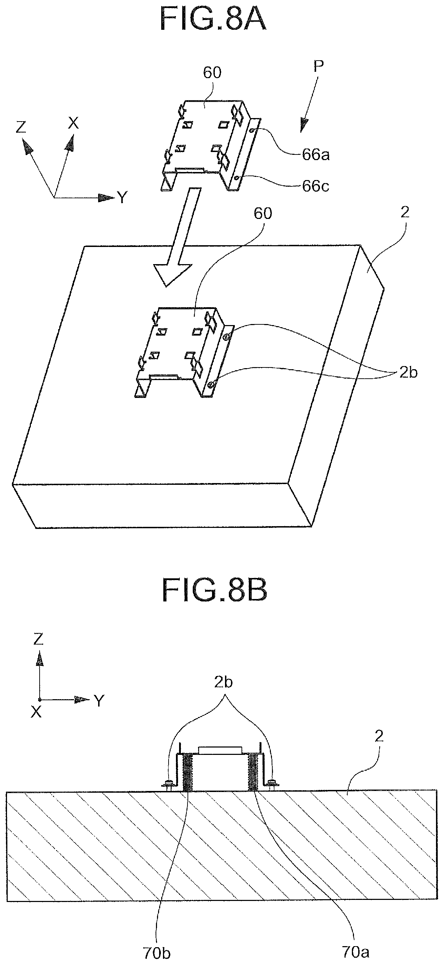

Next, as indicated by the thick arrow in FIG. 8A, the securing step is performed to secure the base unit 60 to the bottom surface (the inner wall 2) at the back of the opening 1a (not illustrated) with the securing unit, which includes the elastic member (coil spring) and the securing member (thread). Here, in FIG. 8A, the illustration of the outer wall 1 is omitted.

More specifically, the thread holes 66a, 66b, 66c, and 66d (see FIG. 5) of the base unit 60 are positioned on the inner wall 2 such that they are aligned with the positions of the thread holes 2a of the inner wall 2, illustrated in FIG. 7B, and threads 2b (securing members) are screwed into the thread holes 2a of the bottom surface (the inner wall 2) such that they are inserted into the thread holes 66a, 66b, 66c, and 66d of the base unit 60, whereby a temporarily secured state is obtained.

FIG. 8B is the side view when the side surface in the temporarily secured state along the X direction in FIG. 8A is viewed from the side of the arrow P. As illustrated in FIG. 8B, the base unit 60 is temporarily secured in the state (floating state) separated from the bottom surface (the inner wall 2) with the securing unit that includes the elastic members 70a, 70b, 70c, 70d, which bias the base unit 60 in a direction away from the bottom surface (the inner wall 2), and the securing member (the thread 2b).

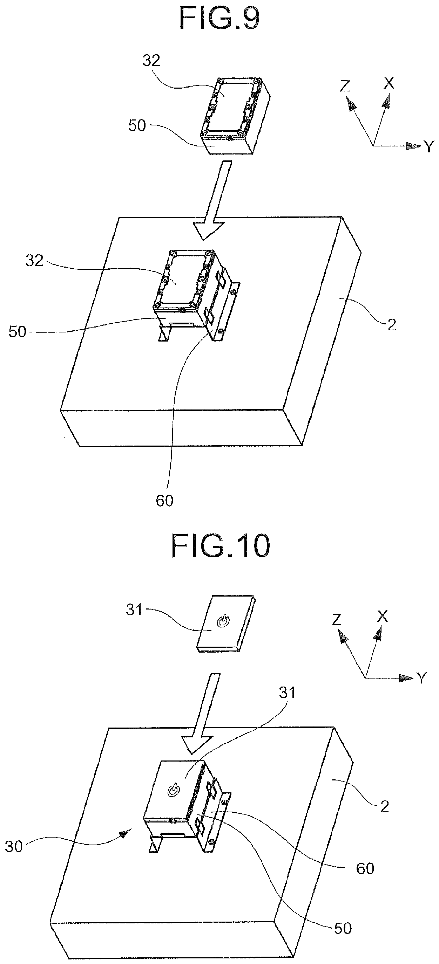

After the securing step to secure the base unit 60 is finished, the supporting step is then performed to cause the base unit 60 to support the sensor module 30, as illustrated in FIG. 9 and FIG. 10.

More specifically, as described above, after the step is performed to attach the sensor main body 32 to the switch box 50, the step is performed to attach the switch box 50 to the base unit 60, as indicated by the thick arrow in FIG. 9. Then, as indicated by the thick arrow in FIG. 10, the step is performed to attach the cover unit 31 to the sensor main body 32, whereby the supporting step is performed to support the sensor module 30 by the base unit 60. Furthermore, in the case of the sensor module 30 that does not include the cover unit 31 but includes only the sensor main body 32, the step to attach the cover unit 31 is omitted from the supporting step.

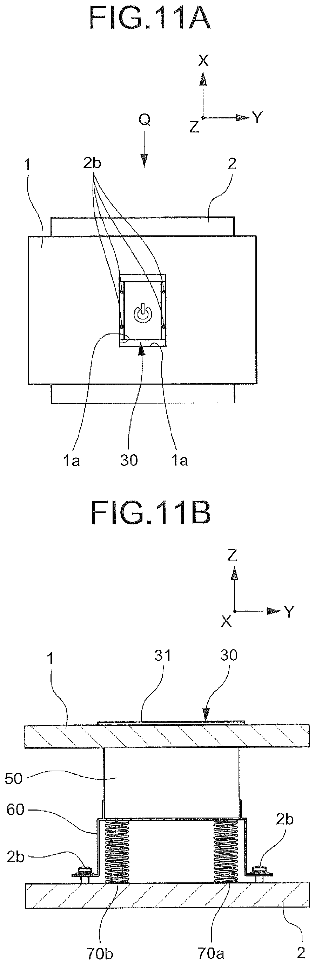

FIG. 11A and FIG. 11B are diagrams that illustrate the state where the supporting step to support the sensor module 30 by the base unit 60 is finished. FIG. 11A is a front view when the outer wall 1 is viewed from the front side, and FIG. 11B is a side view when the side surface along the X direction in FIG. 11A is viewed from the side of the arrow Q.

As illustrated in FIG. 11A, there is a clearance between the opening 1a of the outer wall 1 and the sensor module 30 to such a degree that the thread 2b, which is a securing member, can be seen, and a state is obtained such that the thread 2b may be screwed with a driver, or the like, through the clearance.

Furthermore, as illustrated in FIG. 11B, a state is obtained such that part (the cover unit 31) of the sensor module 30 slightly protrudes from the opening 1a (see FIG. 11A) toward the upper side in the Z direction. Here, FIG. 11B illustrates a case where the cover unit 31 slightly protrudes from the opening 1a; however, if the screwing degree of the thread 2b is large at the time of temporary securing, there is an opposite case where the cover unit 31 is retracted to the back side, i.e., toward the bottom surface (the inner wall 2), from the opening 1a.

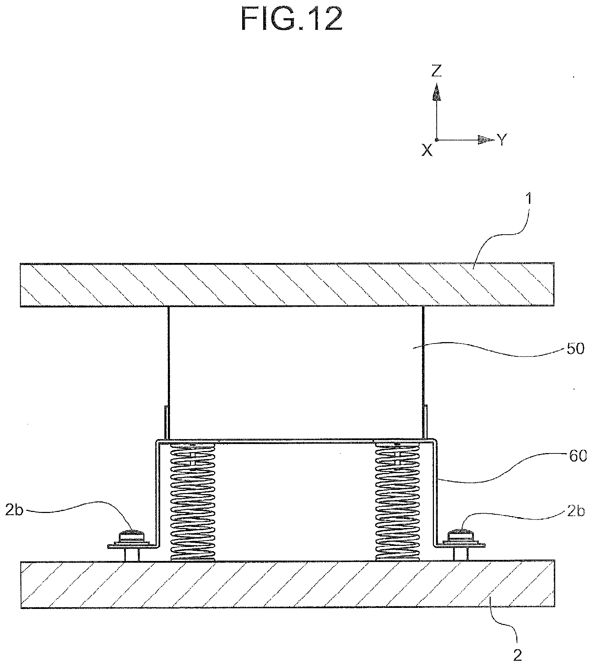

Therefore, next, an adjustment step is performed to adjust the secured state of the securing member (the thread 2b) such that the sensor module 30 is in a predetermined state. More specifically, for example, the screwing degree of the thread 2b, which is a securing member, with respect to the bottom surface (the inner wall 2) is adjusted by using a driver, or the like, so that the cover unit 31, including the flat surface that is located at the opening 1a for the sensor module 30, becomes flush with the opening 1a (the outer wall 1) as in the state of FIG. 11B to the state illustrated in FIG. 12.

That is, the adjustment step is a step at which the secured state of the base unit 60 is adjusted by the securing unit, which includes the elastic members 70a, 70b, 70c, 70d and the securing member (the thread 2b), more specifically, the secured state (the screwing degree with respect to the bottom surface (the inner wall 2)) of the securing member (the thread 2b) is adjusted such that the position and the tilt of the sensor module 30 in the depth direction with respect to the opening 1a is adjusted so that the edge surface (the front surface 31b of the cover unit 31 according to the present embodiment) of the sensor module 30 at the side of the opening 1a is in a predetermined state (the state of being flush according to the present embodiment) with respect to the opening 1a.

Furthermore, the present embodiment illustrates a case where the predetermined state is that the sensor module 30 is flush with the opening 1a (the outer wall 1); however, for example, in a case where the installation area of the plain-face switch 10 is near the floor of a room, if it is slightly tilted upward, the operability of the switch is likely to be improved. In this case, the predetermined state may be a state of being slightly tilted upward.

Furthermore, to obtain flushness, or the like, it is considered that adjustment of the tilt is typically accompanied; however, if there is a need for only adjustment of the depth or conversely if there is a need for only adjustment of the tilt, only the needed adjustment has to be performed, and therefore the adjustment step is sometimes the step to adjust the position or the tilt in the depth direction.

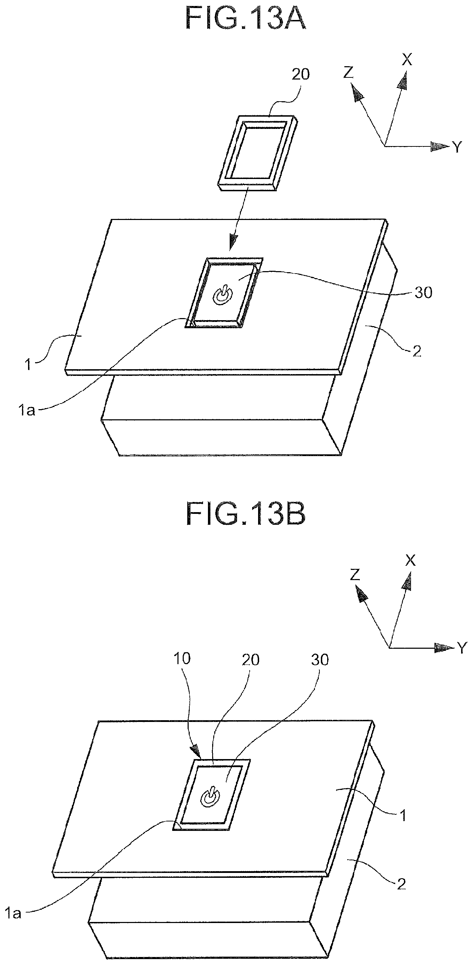

In this way, after the predetermined state is obtained, finally, the packing 20 is attached such that the clearance between the sensor module 30 and the opening 1a is covered, as illustrated in FIG. 13A, and after the clearance is covered with the packing 20 as illustrated in FIG. 13B, attachment of the plain-face switch 10 is finished. Furthermore, after attachment of the plain-face switch 10 is finished, wallpaper, or the like, which is provided with an opening that has such a size that only the sensor module 30 is visible, may be provided on the outer wall 1 so that the packing 20 is not visible.

As described above, with the mounted-type plain-face switch 10 according to the present embodiment, the plain-face switch 10 may be easily secured such that it is flush with the opening 1a, and the design may be improved. Furthermore, the plain-face switch 10 may be easily secured such that it is tilted with respect to the opening 1a.

In the case that is stated in the above description, the plain-face switch 10 is provided on a wall of a house, a conference room, or the like; however, the plain-face switch 10 may be provided on furniture, such as desk or shelf. As for the type of usage of the switch, it may be used as a light switch and it may be also used as a switch for other devices for air conditioning, or the like.

In the plain-face switch 10 according to the first embodiment, the base unit 60 is in the state (floating state) where it is separated from the bottom surface (the inner wall 2) even in the mounted state. Therefore, to prevent the entire plain-face switch 10 from being moved due to the movement of the base unit 60 when the plain-face switch 10 is pushed, it is preferable that the elastic members 70a, 70b, 70c, 70d have such an elastic force that the base unit 60 is immovable even when the plain-face switch 10 is pushed.

### (Second embodiment)

According to the first embodiment, the thread 2b is used as the securing member for securing the base unit 60 to the bottom surface (the inner wall 2); however, as described below in specific, a second embodiment is different in that, instead of the thread 2b, the configuration of the securing member includes a guide pin, which is provided on the bottom surface (the inner wall 2), and an adhesive agent, and it is the same as the first embodiment in other aspects.

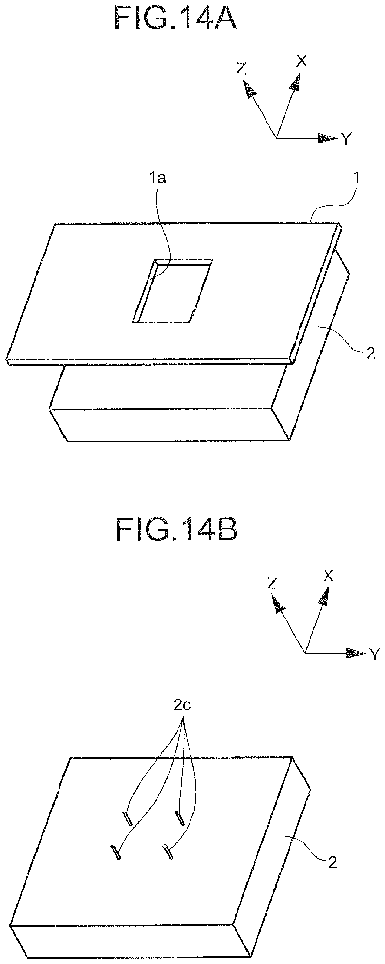

A specific explanation is given below of the configuration of the securing member, which includes the guide pin and the adhesive agent, by stating the different aspect from the attachment method according to the first embodiment. FIG. 14A and FIG. 14B are equivalent to FIG. 7A and FIG. 7B, respectively.

First, in the same manner as in the first embodiment, illustrated in FIG. 7A, the opening 1a is formed on the outer wall 1 according to the second embodiment, too, as illustrated in FIG. 14A. Here, according to the first embodiment, as explained with reference to FIG. 7B, the thread holes 2a are formed on the inner wall 2; however, according to the second embodiment, as illustrated in FIG. 14B, guide pins 2c are provided at the positions that correspond to the thread holes 2a.

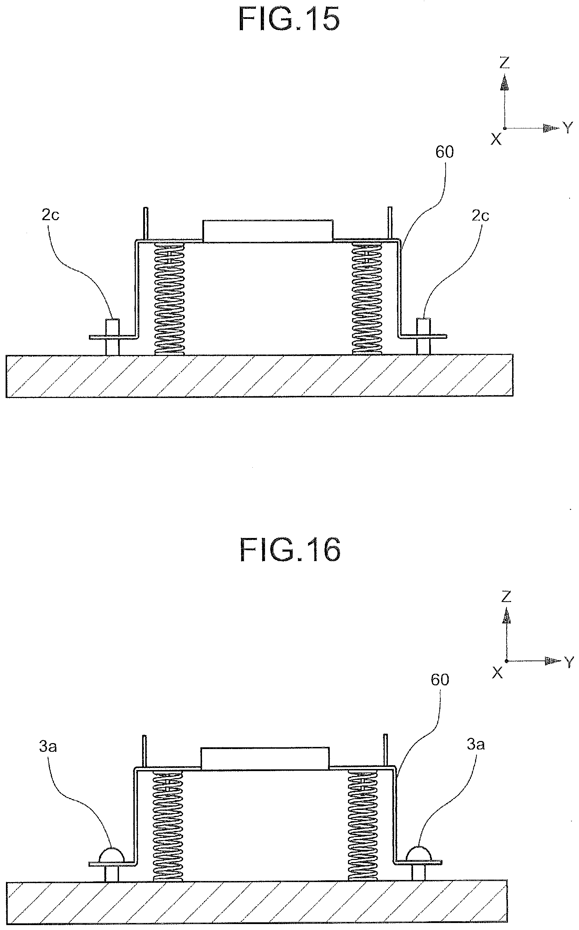

Then, the guide pins 2c are inserted into guide pin holes that are provided in the same manner as the thread holes 66a, 66b, 66c, and 66d (see FIG. 5) of the base unit 60, explained in the first embodiment, so that the base unit 60 is mounted on the bottom surface (the inner wall 2). Here, the inner diameter of the guide pin hole has a size similar to the outer diameter of the guide pin 2c so that backlash of the base unit 60 may be prevented. Then, as illustrated in the figure that is equivalent to FIG. 8B, a state is obtained such that the end of the guide pin 2c is projected from the guide pin hole, as illustrated in FIG. 15, and therefore the end of the guide pin 2c is coated with an adhesive agent 3a, as illustrated in FIG. 16.

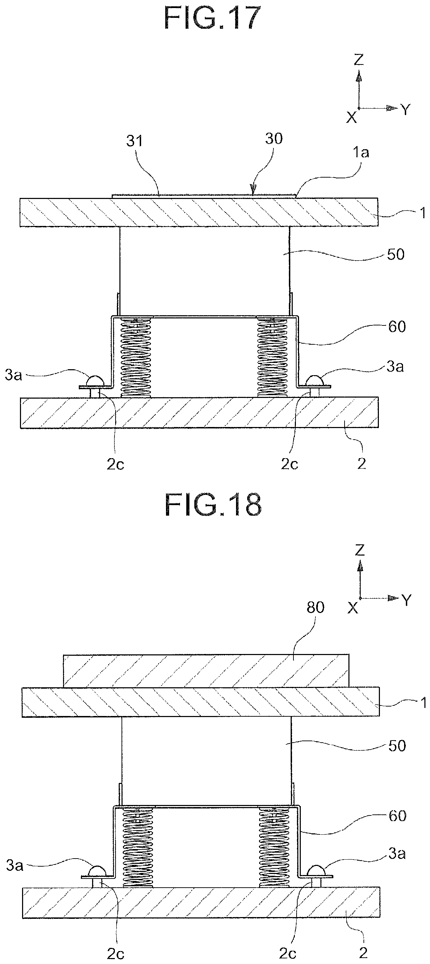

Then, at the same steps as those in the first embodiment, the sensor module 30 is supported by the base unit 60. The state where attachment of the sensor module 30 is finished, i.e., the state that is equivalent to FIG. 11B according to the first embodiment, is as illustrated in FIG. 17, and a state is obtained such that part (the cover unit 31) of the sensor module 30 is slightly projected from the opening 1a.

Next, the adjustment step is performed to adjust the secured state of the securing member such that the sensor module 30 enters a predetermined state; however, according to the second embodiment, instead of adjusting the secured state of the securing member (the thread 2b) as explained in the first embodiment, the adjustment step is changed as illustrated in FIG. 18.

Specifically, as illustrated in FIG. 18, a flat plate 80, which is placed on the outer wall 1, is used, and the flat plate 80 allows part (the cover unit 31) of the sensor module 30, projected from the opening 1a as illustrated in FIG. 17, to be flush with the opening 1a (the outer wall 1). In this way, the predetermined state where it is flush with the opening 1a (the outer wall 1) is retained until the adhesive agent 3a becomes hardened.

That is, a change is made so that adjustment of the secured state of the securing member is conducted such that, although the screwing degree of the thread 2b, which is a securing member, with respect to the bottom surface (the inner wall 2) is adjusted according to the first embodiment, the edge surface (the front surface 31b of the cover unit 31 according to the present embodiment) of the sensor module 30 at the side of the opening 1a is retained at the predetermined state (the state of being flush according to the present embodiment) with respect to the opening 1a while the adhesive agent becomes hardened according to the second embodiment.

Even if the flat plate 80 is removed after the adhesive agent 3a is hardened, part (the cover unit 31) of the sensor module 30 does not protrude from the opening 1a again, and the task of attaching the plain-face switch 10 according to the second embodiment is finished.

As described above, in the case of the second embodiment, as there is no need for the task of adjusting the screwing degree of the thread 2b by inserting the driver as in the first embodiment, the size of the opening 1a may be equal to the size of the sensor module 30, more specifically, the size of the cover unit 31. Therefore, it is not necessary to cover the clearance with the packing 20 as in the first embodiment.

Furthermore, if the size of the opening 1a is equal to the outer shape of the cover unit 31, the task of inserting the base unit 60 to the back of the opening 1a through the opening 1a may be performed such that the base unit 60 is tilted with respect to the opening 1a so that the bent section 65a (see FIG. 5) of the leg section 63a of the base unit 60 and the bent section 65b (see FIG. 5) of the leg section 63b are not obstructed by the opening 1a. Furthermore, according to the second embodiment, if the sensor module 30 needs to be slightly tilted, the tilted state may be retained until the adhesive agent 3a becomes hardened.

The present invention has been explained above on the basis of the embodiments; however, the present invention is not limited to the embodiments, and various modifications may be made without departing from the scope thereof. The above-described embodiment illustrates a case where the cover unit 31 is provided with the mark (indication) of the switch; however, there is no limitation on the mark of the switch being provided on the cover unit 31 itself, and the position of the switch may be indicated by using other methods.

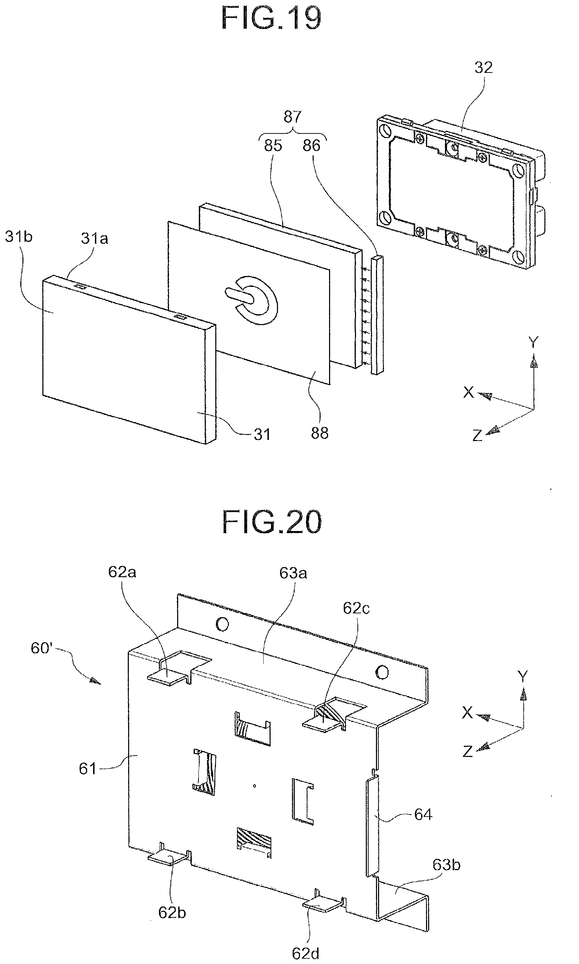

For example, according to a modification of the sensor module 30, illustrated in FIG. 19, the sensor module 30 includes a backlight 87 between the sensor main body 32 and the cover unit 31 and an indication unit 88 between the backlight 87 and the cover unit 31 so that the mark of the switch may be indicated.

More specifically, the cover unit 31 is made of a light transmissive material and the indication of the indication unit 88 is projected onto the cover unit 31 by the backlight 87 so that the mark of the switch, or the like, may be indicated. As the indication unit 88, it is possible to use a transparent plate, on which the mark of the switch is depicted, or a liquid crystal device that displays the mark of the switch. Furthermore, as the backlight 87, it is possible to use the one that includes a light guide plate 85 and a light source 86 that emits light to the light guide plate 85 as used in liquid crystal devices, or the like.

In the case of this configuration, if the back surface 31a of the cover unit 31 at the side of the sensor main body 32 is provided with a half mirror (not illustrated), the mark of the switch may be indicated only when the backlight 87 is turned on.

Furthermore, if only part of the wallpaper, corresponding to the plain-face switch 10, is optically transmissive to such a degree that when the backlight 87 is turned on, the mark of the switch emerges, it is possible to develop a design of the wall such that the presence of the plain-face switch 10 is not visible at the normal time. In this case, for example, in conjunction with a human sensor, or the like, the backlight 87 may be turned on so that the mark of the switch is indicated only when someone is approaching.

Furthermore, without the provision of the half mirror, the indication may be directly printed on the cover unit 31, which is formed with a light transmissive material, so that the indication is lighted up by the backlight 87. Especially at the night, or the like, the indication by only printing is hard to be visible; however, the above lighting-up allows the configuration to instantly know where the switch is located. Furthermore, the present embodiment describes the case where the mark of the switch is indicated; however, changes may be appropriately made as to what kind of mark is indicated, and there is no limitation on the mark of the switch.

Furthermore, in the case of the first embodiment, too, as illustrated in FIG. 11A, the size of the opening 1a does not necessarily need to be larger than the outer shape of the sensor module 30. A configuration may be such that the size of the opening 1a is substantially the same as the size of the sensor module 30 and a hole is provided on part of the outer wall 1, corresponding to the thread 2b. In this case, the packing 20 may conform to the shape of the hole on the outer wall 1, provided corresponding to the thread 2b.

Furthermore, the first embodiment and the second embodiment describe the configuration where the elastic members 70a, 70b, 70c, 70d are provided at the four corners of the back surface of the plane section 61 of the base unit 60; however, there is no limitation on this configuration.

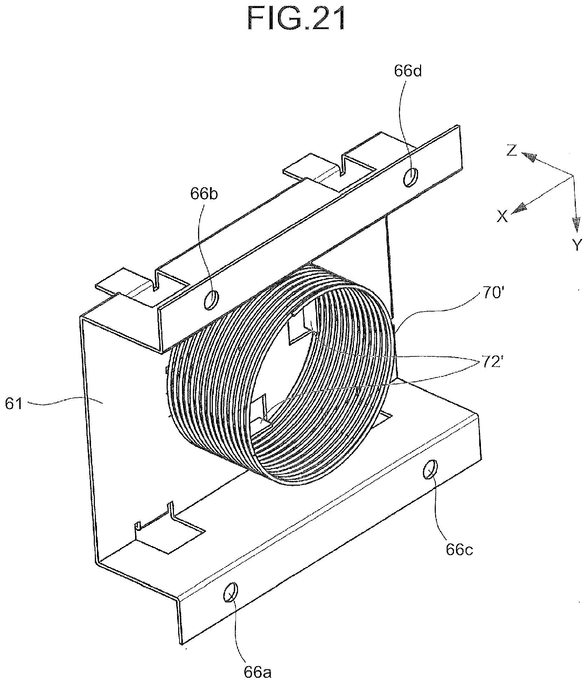

For example, the configuration maybe the modification that is illustrated in FIG. 20 and FIG. 21. FIG. 20 is a perspective view that illustrates a base unit 60' according to the modification as viewed from the front side, the direction of the illustration is the same as that of the base unit 60 that is illustrated in FIG. 2, and FIG. 21 is a perspective view as viewed from the back surface side in FIG. 20. In FIG. 20 and FIG. 21, the same components as those in the first embodiment are attached with the same number with their explanations omitted, and only different points are principally explained.

As illustrated in FIG. 20 and FIG. 21, according to the modification, an elastic member 70' is only one elastic member that is provided between the base unit 60' and the undepicted bottom surface (the inner wall 2). Furthermore, as illustrated in FIG. 21, the elastic member 70' is provided such that it is located at the center of the plane section 61.

Furthermore, the base unit 60' is provided with protruding sections 72' that abut the inner circumference of the elastic member 70', arranged at substantially 90°. More specifically, the four protruding sections 72', protruding from the plane section 61 toward the side of the undepicted bottom surface (the inner wall 2), are provided at two areas located away in the X direction and at two areas located away in the Y direction, and the four protruding sections 72' are provided such that they are located at the positions with the same distance with reference (origin) to the center of the plane section 61.

Furthermore, the distance between the protruding sections 72' at two areas, located away in the X direction, is a distance that nearly equals the inner diameter of the elastic member 70', which is a coil spring. The distance between the protruding sections 72' at two areas, located away in the Y direction, is also a distance that nearly equals the inner diameter of the elastic member 70'.

Furthermore, the inner circumference of the elastic member 70' abuts the four protruding sections 72', and the elastic member 70' is attached to the base unit 60' such that the elastic member 70' is engaged with the protruding section 72'; thus, in the same manner as described in the first embodiment, the elastic member 70' is prevented from being separated from the base unit 60' when the task of attaching the plain-face switch 10 is performed.

The length of the used elastic member 70' is also longer than the lengths of the leg sections 63a, 63b of the base unit 60' in a state where it is fully stretched without any loads being applied. Therefore, the base unit 60' may be fixed in the state (floating state) where it is separated from the undepicted bottom surface (the inner wall 2) in the same manner as the base unit 60 according to the first embodiment, and by adjusting the screwing degree of the threads 2b (not illustrated), which are screwed into the undepicted bottom surface (the inner wall 2) through the thread holes 66a, 66b, 66c, and 66d, with respect to the bottom surface (the inner wall 2), the position and the tilt in the depth direction may be changed.

Thus, according to the modification that is illustrated in FIG. 20 and FIG. 21, the same operation and function as those in the above-described embodiment may be achieved. Furthermore, if there is one elastic member as in the modification, it is preferable that a large elastic member is used to receive the base unit 60' in a stable manner.

Thus, the present invention is not limited to specific embodiments, it includes various changes made, and it is obvious to a person skilled in the art from the description in claims.

Furthermore, as explained in detail in the embodiments, or the like, the detailed explanation of the invention also describes the invention related to a method for attaching a plain-face switch as noted below.

### [Note 1]

A method for attaching a mounted-type plain-face switch that is attachable such that a sensor module is located at an opening, the method comprising:
securing a base unit to a bottom surface at back of the opening with a securing unit;
supporting the sensor module by the base unit such that a flat sensor surface faces side of the opening; and
adjusting a secured state of the base unit by the securing unit so as to adjust a position or a tilt of the sensor module in a depth direction with respect to the opening such that an edge surface of the sensor module at the side of the opening enters a predetermined state with respect to the opening.

### [Note 2]

The attachment method according to note 1, wherein the predetermined state is a state where the edge surface of the sensor module at the side of the opening is flush with the opening.

### [Note 3]

The attachment method according to note 1 or 2, wherein
the securing unit includes an elastic member, which is provided between the base unit and the bottom surface, and a securing member that secures the base unit to the bottom surface, and
the adjusting is adjusting a secured state of the securing member to obtain the predetermined state.

### [Note 4]

The attachment method according to note 3, wherein
the base unit includes a rectangular plane section and leg sections that extend from at least two opposing sides of the plane section toward the bottom surface,
the elastic member is provided at least at four corners or a center of the plane section,
the securing member is provided at least on the leg section in neighborhood of the four corners of the plane section, and
the adjusting the secured state of the securing member is adjusting the secured state of each securing member to obtain the predetermined state.

### [Note 5]

The attachment method according to note 3 or 4, wherein
the securing member is a thread, and
the adjusting the secured state of the securing member is adjusting a screwing degree of the thread with respect to the bottom surface.

### [Note 6]

The attachment method according to note 3 or 4, wherein
the securing member includes a guide pin that is secured to the bottom surface and an adhesive agent that attaches the base unit to the guide pin, and
the adjusting the secured state of the securing member is conducted such that the adhesive agent becomes hardened while the edge surface of the sensor module at the side of the opening is retained at a predetermined state with respect to the opening.

### [Note 7]

The attachment method according to any one of notes 1 to 6, wherein
the sensor module includes a sensor main body and a cover unit that is attached to the sensor main body at the side of the opening, and
the supporting includes
attaching the sensor main body to a switch box; and
attaching the switch box to the base unit.

### Reference Signs List

1a OPENING
2 INNER WALL (BOTTOM SURFACE)
2b THREAD
10 PLAIN-FACE SWITCH
20 PACKING
30 SENSOR MODULE
31 COVER UNIT
32 SENSOR MAIN BODY
33 SENSOR UNIT
34 SECURING PLATE
35 SECURING BOX
40 SPACER
50 SWITCH BOX
60 BASE UNIT
61 PLANE SECTION
63a LEG SECTION
63b LEG SECTION
70a ELASTIC MEMBER
70b ELASTIC MEMBER
70c ELASTIC MEMBER
70d ELASTIC MEMBER
70' ELASTIC MEMBER
72d PROTRUDING SECTION
72' PROTRUDING SECTION
73d LOCKING PROJECTION

## Claims

1. A mounted-type plain-face switch that is mounted into an opening, the plain-face switch comprising:
a base unit that is provided at back of the opening;
a sensor module that has a flat sensor surface facing side of the opening and that is supported by the base unit; and
a securing unit that secures the base unit to a bottom surface that is located at the back of the opening, wherein
the securing unit is capable of adjusting a position or a tilt of the sensor module in a depth direction with respect to the opening such that an edge surface of the sensor module at side of the opening enters a predetermined state with respect to the opening.

2. The plain-face switch according to claim 1, wherein the securing unit includes
an elastic member that is provided between the base unit and the bottom surface and that is attached to the base unit; and
a securing member that secures the base unit to the bottom surface.

3. The plain-face switch according to claim 2, wherein
the base unit includes a rectangular plane section and leg sections that extend from at least two opposing sides of the plane section toward the bottom surface,
the elastic member is provided at least at four corners or a center of the plane section, and
the securing member is provided at least on the leg section in neighborhood of the four corners of the plane section.

4. The plain-face switch according to claim 2 or 3, wherein
the securing member is a thread, and
the plain-face switch comprises a packing that is provided to cover a clearance between
the sensor module and an edge of the opening.

5. The plain-face switch according to claim 2 or 3, wherein the securing member includes a guide pin that is secured to the bottom surface and an adhesive agent that attaches the base unit to the guide pin.

6. The plain-face switch according to any one of claims 2 to 5, wherein
the elastic member is a coil spring,
the base unit includes a protruding section that protrudes toward the bottom surface and that has one end side of the coil spring fitted therewith, and
the protruding section is provided with a locking projection that locks the coil spring.

7. The plain-face switch according to any one of claims 1 to 6, wherein the sensor module includes a capacitance-type sensor unit.

8. The plain-face switch according to any one of claims 1 to 7, wherein the sensor module includes
a cover unit that is provided on side of the opening and that is located at the opening; and
a sensor main body to which the cover unit is attached.

9. The plain-face switch according to claim 8, wherein
the sensor module includes
a backlight that is provided between the cover unit and the sensor main body; and an indication unit that is provided between the backlight and the cover unit, and the cover unit is made of a light transmissive material.

10. The plain-face switch according to claim 8, wherein
the sensor module includes a backlight that is provided between the cover unit and the sensor main body, and
the cover unit is made of a light transmissive material and has an indication printed thereon.

11. The plain-face switch according to any one of claims 8 to 10, comprising a switch box to which the sensor main body is attached, wherein
the switch box is attached to the base unit at the side of the opening so that the sensor module is supported by the base unit via the switch box.

12. The plain-face switch according to claim 11, comprising a spacer that is attached to the switch box, wherein
the sensor main body includes
a securing box that is attached to the spacer;
a securing plate that is attached to the securing box; and
a sensor unit that is attached to the securing plate.

13. The plain-face switch according to any one of claims 1 to 12, wherein the securing unit is capable of adjusting a position and a tilt of the sensor module in a depth direction with respect to the opening so that the predetermined state is obtained such that the edge surface of the sensor module at the side of the opening is flush with the opening.

14. A method for attaching a mounted-type plain-face switch that is attachable such that a sensor module is located at an opening, the method comprising:
securing a base unit to a bottom surface at back of the opening with a securing unit;
supporting the sensor module by the base unit such that a flat sensor surface faces side of the opening; and
adjusting a secured state of the base unit by the securing unit so as to adjust a position or a tilt of the sensor module in a depth direction with respect to the opening such that an edge surface of the sensor module at the side of the opening enters a predetermined state with respect to the opening.
